# EUROPÄISCHE PATENTSCHRIFT

(11) **EP 1 050 076 B1**
(45) Veröffentlichungstag und Bekanntmachung des Hinweises auf die Patenterteilung: **22.10.2003**
(21) Anmeldenummer: 99904726.9
(22) Anmeldetag: 21.01.1999
(51) Int. Cl.: H01L 21/329, H01L 29/866

(54) **VERFAHREN ZUR HERSTELLUNG VON DIODEN**
METHOD FOR PRODUCING DIODES
PROCEDE DE PRODUCTION DE DIODES

(30) Priorität: 21.01.1998 DE 19802090; 11.12.1998 DE 19857243
(43) Veröffentlichungstag der Anmeldung: 08.11.2000
(73) Patentinhaber: ROBERT BOSCH GMBH, 70442 Stuttgart (DE)
(72) Erfinder: GOEBEL, Herbert, D-72766 Reutlingen (DE); GOEBEL, Vesna, D-72766 Reutlingen (DE)
(86) Internationale Anmeldenummer: DE9900164
(87) Internationale Veröffentlichungsnummer: WO99038205

(56) Entgegenhaltungen:
- DE-A- 4 320 780

## Beschreibung

### Stand der Technik

Die Erfindung geht aus von einem Verfahren das bereits aus der DE 43 20 780 bekannt ist, in dem Dotierfolien eingesetzt werden und wobei das Herstellen der Teilschichten in einem einzigen Dotierschritt erfolgt.

### Vorteile der Erfindung

Das erfindungsgemäße Verfahren des Hauptanspruchs hat demgegenüber den Vorteil, daß flachere Dotierprofile hergestellt werden können, bei denen die Oberfächenkonzentration niedriger liegen kann. Dadurch, daß es möglich wird, ein flaches Auslaufen der Dotierkonzentration in die Tiefe des Wafers herzustellen, wird die Flußspannung der Diode niedriger. Ebenso wird die Durchbruchspannung bei hohen Strömen, z. B. 100 A, deutlich verkleinert, also der Bahnwiderstand in der Diode verringert. Ferner ist die Diode einfacher herstellbar, da die Zenerspannung der Diode weniger empfindlich gegen gewisse Schwankungen bei einer zweiten Diffusion in einer Serienfertigung ist, durch die der eigentliche PN-Übergang hergestellt wird. Dadurch, daß es möglich wird, bei gleichzeitig tiefem Ausläufer der Dotierkonzentration eine geringe Oberflächenkonzentration zu erzeugen, kann eine zweite Diffusion, durch die der PN-Übergang hergestellt wird, mit einer niedriger dotierten Dotierfolie durchgeführt werden. Damit kann die Zenerspannung in einer Serienfertigung besser "getroffen" bzw. eingehalten werden, ohne besondere Vorkehrungen zu treffen. Durch die möglich werdende schwächere zweite Dotierung wird auch die Oberfäche des Siliziumwafers nicht so stark mit Fremdatomen angereichert, so daß das Siliziumkristallgitter nicht gestört und damit eine Verbiegung der Wafer vermieden wird. Vorteilhaft ist außerdem, daß die verwendete Neutralfolie gleichzeitig als Schutz beim weiteren Eintreiben dient. Sie wird auf eine bereits dotierte Siliziumoberfläche aufgelegt und verhindert beim weiteren Eintreiben der Dotieratome ohne zusätzliche Oberflächenbelegung sicher eine Oberflächenverunreinigung.

Durch die in den abhängigen Ansprüchen aufgeführten Maßnahmen sind vorteilhafte Verbesserungen des im Hauptanspruch angegebenen Verfahrens möglich. Besonders vorteilhaft ist eine Belegung der Oberseite des Wafers mit einer Neutralfolie in einem zweiten Teilschritt, wobei die Unterseite des Wafers mit einer Dotierfolie für sehr starke Dotierung belegt wird. Dadurch wird es möglich, zum einen ein tiefes Dotierprofil zu erhalten, zum anderen, die Unterseite des Wafers gleichzeitig verstärkt zu dotieren, um eine gute Rückseitenanbindung der Diode zu ermöglichen.

Die weitere Applikation einer Dotierfolie entgegengesetzten Leitfähigkeitstyps ermöglicht ein einfaches und zudem fehlertolerantes Herstellen des PN-Übergangs der Diode.

Zeichnung

Ausführungsbeispiele der Erfindung sind in der Zeichnung dargestellt und in der nachfolgenden Beschreibung näher erläutert.

Es zeigen Figur 1 einen Zenerdiodenchip, Figur 2 Verfahrensschritte zur Herstellung und Figur 3 Dotierkonzentrationsverläufe. Figur 4 zeigt weitere Dotierkonzentrationsverläufe.

### Beschreibung der Ausführungsbeispiele

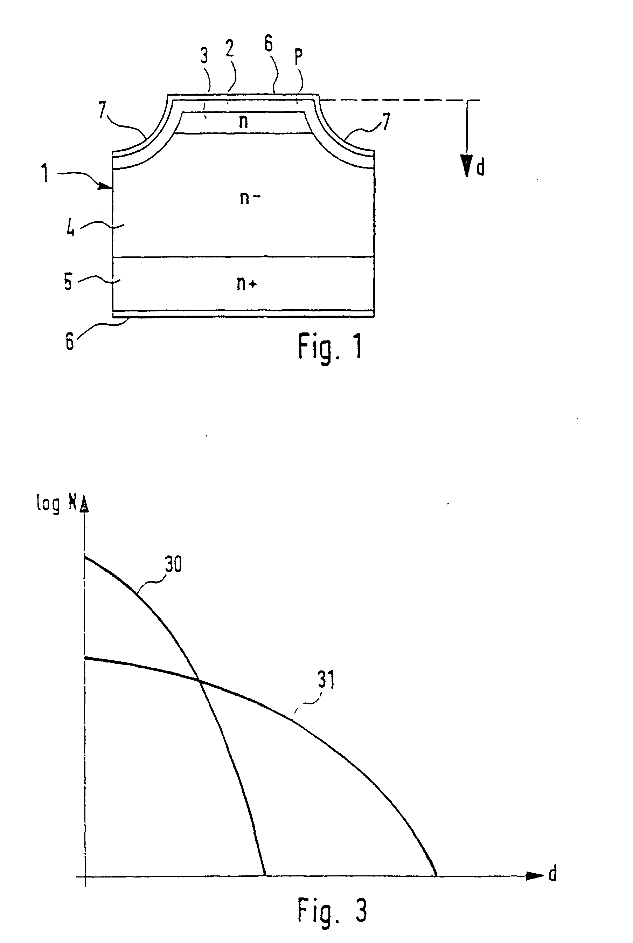

Figur 1 zeigt eine gemäß dem erfindungsgemäßen Verfahren hergestellte Zenerdioden-Anordnung in einem Chip 1. Der Chip weist eine n-dotierte Schicht 3, eine darunterliegende schwach n-dotierte Schicht 4 und eine unter der Schicht 4 liegende stark n-dotierte Schicht 5 auf. Die Oberseite des Chips 1 ist von einer p-dotierten Schicht 2 bedeckt, wobei der Chip im Randbereich der Oberseite Stufen 7 aufweist, so daß die p-Schicht 2 im Mittelbereich der Oberseite die n-Schicht 3 bedeckt, während sie im Randbereich der Oberseite die schwach n-dotierte Schicht 4 bedeckt. Sowohl die P-Schicht 2 als auch die stark n-dotierte Schicht 5 sind mit einer Metallisierung 6 bedeckt. Mit d ist die Eindringtiefe von n-Dotieratomen von der Oberseite des Wafers in das Waferinnere bezeichnet.

Die Metallisierungen 6 dienen als Anoden- bzw. Kathodenkontaktierung der Zenerdiode, wobei eine gute Rückseitenanbindung über die stark n-dotierte Schicht 5 gewährleistet ist. Der pn-Übergang der Zenerdiode wird durch den Übergang zwischen der Schicht 2 und der Schicht 3 gebildet.

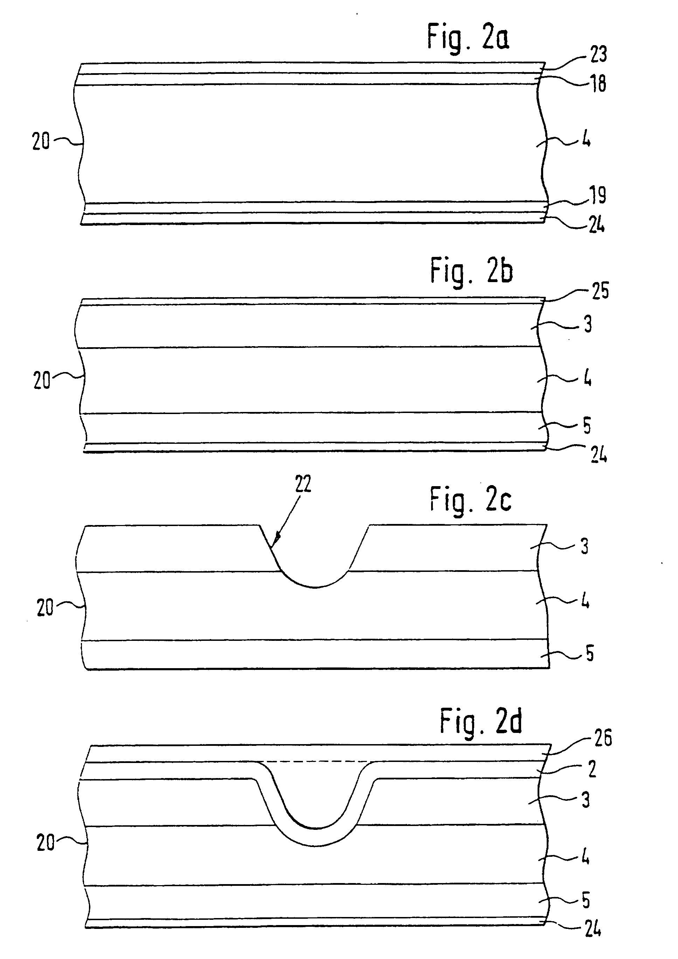

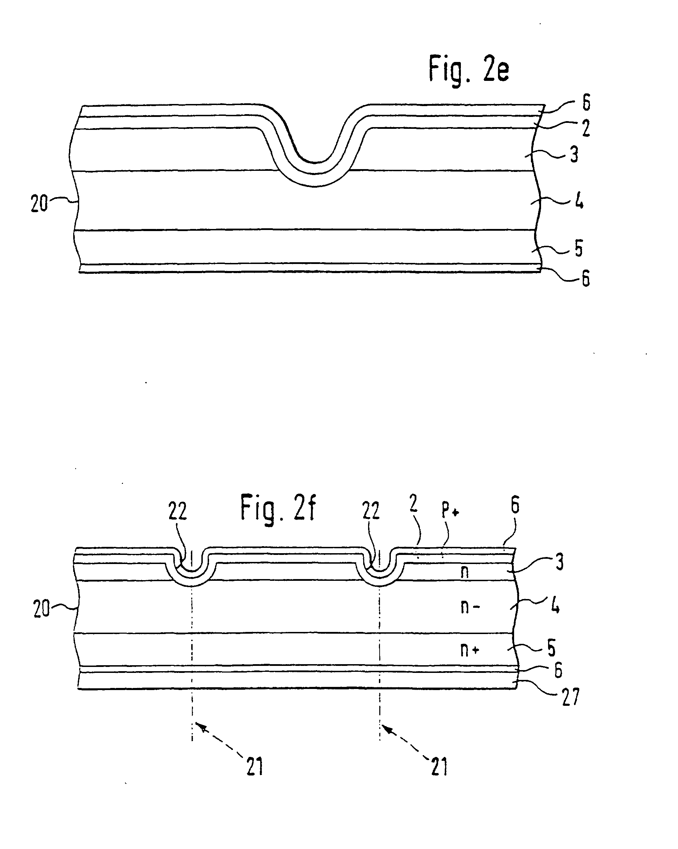

Figur 2 zeigt ein Ausführungsbeispiel des erfindungsgemäßen Verfahrens. Figur 2a zeigt einen Wafer 20, der auf der Oberseite mit einer ersten Dotierfolie 23 und auf der Unterseite mit einer zweiten Dotierfolie 24 belegt ist. Dabei dient die erste Dotierfolie zur Herstellung stark n-dotierter Schichten, die zweite Dotierfolie hingegen zur Herstellung sehr stark n-dotierter Schichten. Der Wafer 20 ist vom n-Typ und weist die Dotierkonzentration der späteren n-Schicht 4 auf. Der Wafer 20 wird zusammen mit anderen Wafern gestapelt. Dabei liegen zwischen den Wafern 20 alternierend erste bzw. zweite Dotierfolien. Der Waferstapel wird ungefähr 30 Minuten bis ca. 3 Stunden lang bei ca. 1200° bis 1300° C in einem Diffusionsofen in oxidierender Atmosphäre erhitzt. Durch diese Behandlung bildet sich an der Oberseite eine stark n-dotierte Belegungsschicht 18 und an der Unterseite eine sehr stark n-dotierte Belegungsschicht 19 aus. Anschließend werden die Wafer getrennt und entstandene Oxidschichten entfernt. In einem weiteren Schritt erfolgt ein Eintreiben des Dotierstoffes, der in den Belegungsschichten 18 und 19 abgelegt ist. Dies geschieht ebenfalls durch Stapeln der Wafer, jedoch sind jetzt (Figur 2b) im Vergleich zum vorangegangenen Schritt (Figur 2a) die Vorderseite der Wafer jeweils mit einer Neutralfolie 25 und die Rückseiten mit einer sehr stark n-dotierten Dotierfolie 24 belegt, das heißt, diesmal alternieren Neutralfolien und Dotierfolien 24 zwischen den Wafern des Waferstapels. Dieser Waferstapel wird ca. 30 bis 120 Stunden lang bei 1200° C bis 1300° C im gleichen Diffusionsofen wie vorhin in oxidierender Atmosphäre erhitzt. Anschließend erfolgt wieder ein Trennen der Wafer und das Entfernen entstandener Oxidschichten. Durch diese zweite Erhitzung im Waferstapel bildet sich die n-dotierte Schicht 3 und die stark n-dotierte Schicht 5 aus. In einem weiteren Schritt (Figur 2c) werden Gräben 22 in die Oberseite der Wafer eingebracht. Dies kann durch Sägen oder in einem Ätzprozeß erfolgen. Die Gräben 22 durchdringen dabei vollständig die Teilschicht 3 und ragen in die Schicht 4 hinein. Durch die Gräben 22 werden Zerteilungslinien 21 definiert (siehe Figur 2f), entlang denen später der Wafer in einzelne Zenerdiodenchips zerteilt wird. Die Oberseite des Wafers 20 wird also durch das Einsägen der als Randstruktur der späteren Dioden dienenden Gräben 22 in quadratische oder rechteckige Segmente aufgeteilt (nicht abgebildet), die den späteren Oberseiten der einzelnen Chips entsprechen. Anschließend erfolgt ein Spülen der angeritzten Wafer in deionisiertem Wasser. In einem weiteren Schritt (Figur 2d) erfolgt die Herstellung des PN-Übergangs der Dioden. Dabei wird ebenfalls eine Foliendiffusion ausgeführt, indem die Teilschicht 3 mit einer vierten Dotierfolie 26 vom p-Typ belegt wird. Bei einer Diffusionszeit von 15 - 30 Stunden und einer Ofentemperatur von 1200° - 1300° C bildet sich an der Oberseite des Wafers eine p-Schicht 2 aus, die die Teilschicht 3 und (in den Gräben 22) die Schicht 4 bedeckt. Selbst wenn die Dotierfolie 26 die Gräben 22 nicht vollständig auskleidet, sondern wie in Figur 2d gezeigt, lediglich überdeckt, bildet sich in den Gräben eine durchgehende p-Schicht 2 aus, da bei den hohen Temperaturen der Dotierstoff in flüssiger Form auf der Waferoberfläche vorliegt und somit auch in die Gräben gelangt. Bei diesem Diffusionsschritt kann wahlweise die Rückseite des Wafers 20 weiterhin mit der zweiten Dotierfolie 24 belegt sein, so daß auch dieser Diffusionsschritt im Waferstapel erfolgen kann. In einem weiteren Schritt (Figur 2e) werden Ober- und Unterseite des Wafers 20 mit einer Metallisierung 6 versehen. Anschließend (Figur 2f) wird die Unterseite des Wafers auf eine Sägefolie 27 geklebt und der Wafer entlang der Zerteilungslinien 21 durchsägt, wodurch eine Vereinzelung der parallel im Waferverbund hergestellten Dioden erfolgt.

Wahlweise kann der in Figur 2b dargestellte Verfahrensschritt nach dem Einbringen der Gräben 22 (Figur 2c) durchgeführt werden, dadurch erzielt man in vorteilhafter Weise eine Ausheilung von durch das Einbringen der Gräben 22 entstandenen Kristallschäden. Als p-Dotierstoff wird beispielsweise Bor, als n-Dotierstoff Phosphor verwendet.

Wahlweise kann die Belegung der Ober- bzw. Unterseite des Wafers 20 mit einer starken bzw. sehr starken Konzentration an n-Dotieratomen statt durch Belegung mit Folien (wie in Figur 2a dargestellt) auch durch eine Gasphasenbelegung, ein Spin-on-Verfahren unter Verwendung von Dotierflüssigkeiten und/oder mittels Ionenimplantation bzw. sonst bekannter Dotierverfahren erfolgen.

Das in Figur 2a beschriebene Vorgehen der Bedeckung mit Dotierfolien (insbesondere in Kombination mit einer Stapeltechnik) hat gegenüber den alternativ genannten Vorgehensweisen den Vorteil, einfach und daher gut für die Großserienfertigung geeignet zu sein.

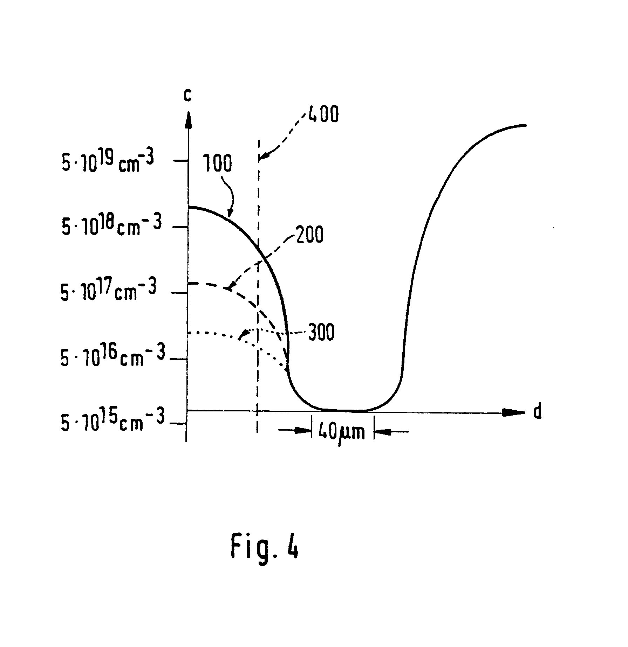

Figur 3 zeigt ein Diagramm, das den Verlauf von Dotierstoffkonzentrationen N über der Eindringtiefe d darstellt. Dabei ist ein bekanntes Dotierprofil 30 einem neuen Dotierprofil 31 gegenübergestellt, wie es mit dem erfindungsgemäßen Verfahren hergestellt werden kann. Hierbei ist die Konzentration der n-Dotieratome dargestellt, wie sie sich in ihrem Tiefenverlauf durch die zwei Diffusionsteilschritte ergeben, wie in Figur 2a und 2b dargestellt sind. Durch das flache neue Dotierprofil 31, das tief in den Wafer hineinreicht (40 - 110 µm), erhält man Zenerdioden, deren Flußspannung im Vergleich zu Zenerdioden mit bekanntem Dotierprofil 30 deutlich reduziert ist. Außerdem reduziert sich die Durchbruchsspannung bei hohen Strömen, (z. B. 100 A) um über 20 % durch das erfindungsgemäße Verfahren im Vergleich zum bekannten Verfahren der DE 43 20 780. Mit dem erfindungsgemäßen Verfahren können Dioden hergestellt werden, die impulsfest sind, eine niedrige Flußspannung und eine geringe Streuung der Zenerspannung aufweisen. Dabei ist durch die homogene Belegung mit Dotierfolien und das tiefe Eintreiben unter Verwendung von Neutralfolien eine hohe Ausbeute erzielbar.

Figur 4 zeigt drei Dotierkonzentrationsverläufe 100, 200 und 300 in einem Diagramm der Dotierstoffkonzentration c in Abhängigkeit vom Ort d (zur Definition des Orts d, vergleiche Figur 1). Diese Profile beziehen sich auf den Zustand eines 200 Mikrometer dicken Wafers unmittelbar nach dem in Figur 2b dargestellten Verfahrensschritt. Der Verlauf 100 ist beispielsweise für die Herstellung von Zenerdioden mit einer Zenerspanung zwischen 19 und 25 Volt vorgesehen, der Verlauf 200 bzw. 300 für Zenerspanungen zwischen 34 und 40 Volt beziehungsweise zwischen 50 und 56 Volt vorgesehen. Dabei entspricht der Bereich 4 der Figur 1 der in Figur 4 mit der Breitenangabe von 40 Mikrometer markierten Zone. Diese Breite ist jedoch für die Einstellung einer bestimmten Zenerspannung unerheblich, sie kann auch andere Werte (typisch 20µm-120µm) einnehmen. Die gestrichelte Linie 400 markiert die Lage des in dem Verfahrensschritt der Figur 2d hergestellten pn-Übergangs außerhalb des vertieften Bereiches 22.

Die dargestellten unterschiedlichen Dotierkonzentrationsverläufe können durch Wahl einer Dotierfolie 23 mit geeigneter Konzentration an Dotieratomen je nach gewünschter Zenerspanung ausgewählt werden. Alternativ oder in Kombination kann die Zeit der Belegung des Wafers mit der Dotierfolie 23 variiert werden zur Variation einer später resultierenden Zenerspanung. Die Durchbruchspanung im Randbereich der fertigen Einzeldioden bleibt dann infolge der Grabenstruktur unberührt und hat beispielsweise stets den Wert 140 Volt. Alternativ oder in Kombination mit der Wahl einer niedriger dotierten Dotierfolie 23 zur Erhöhung der Zenerspanung kann eine höher dotierte Dotierfolie 26 im Herstellungsverfahren eingesetzt werden.

Wahlweise kann auch hier die Belegung der Ober- bzw. Unterseite des Wafers 20 mit einer starken bzw. sehr starken Konzentration an n-Dotieratomen statt durch Belegung mit Folien (wie in Fig. 2a dargestellt) auch durch eine Gasphasenbelegung, ein Spin-on-Verfahren unter Verwendung von Dotierflüssigkeiten und/oder mittels Ionenimplantation bzw. sonst bekannter Dotierverfahren erfolgen.

## Patentansprüche

1. Verfahren zur Herstellung von Halbleiteranordnungen mit den Verfahrensschritten:
- Herstellen eines Wafers (20) mit einer oberen Teilschicht (3), einer darunter liegenden zweiten Teilschicht (4) und einer unten liegenden Teilschicht (5), wobei alle Teilschichten (3,4,5) den gleichen Leitungstyp aufweisen, die Dotierstoffkonzentration der ersten Teilschicht (3) größer ist als die Dotierstoffkonzentration der zweiten Teilschicht (4) und die Dotierstoffkonzentration der unten liegenden Teilschicht (5) größer ist als die Dotierstoffkonzentrationen der oberen und der zweiten Teilschicht,
- Einbringen von Gräben (22) in die Oberseite des Wafers (29), die durch die erste Teilschicht (3) hindurch bis in die zweite Teilschicht (4) reichen,
- Einbringen von Dotierstoffen in die Oberseite des Wafers (20), die den Leitfähigkeitstyp einer ersten Schicht (2) der ersten Teilschicht (3) verändern,
- Aufbringen einer Metallisierung (6) auf der Ober- und der Unterseite des Wafers (20),
- Zerteilen des Wafers in einzelne Chips (1) entlang der eingebrachten Gräben (22),
wobei das Herstellen der Teilschichten (3, 4, 5) erfolgt, indem
- in einem ersten Teilschritt die Oberseite mit einer starken Konzentration an Dotieratomen und die Unterseite mit einer sehr starken Konzentration an Dotieratomen belegt wird und
- in einem weiteren Teilschritt ein Eintreiben der Dotieratome erfolgt, wobei die Oberseite mit einer Neutralfolie und die Unterseite mit einer Dotierfolie (24) für sehr starke Dotierung bedeckt wird.

2. Verfahren nach Anspruch 1, **dadurch gekennzeichnet, daß** im ersten Teilschritt die Oberseite mit einer Dotierfolie (23) für starke Dotierung und die Unterseite mit der Dotierfolie (24) für sehr starke Dotierung bedeckt wird.

3. Verfahren nach Anspruch 1, **dadurch gekennzeichnet, daß** der erste Teilschritt mittels einer Gasphasenbelegung, mittels eines Spin-On-Verfahrens mit einer Dotierflüssigkeit und/oder mittels Ionenimplantation erfolgt.

4. Verfahren nach einem der vorhergehenden Ansprüche, **dadurch gekennzeichnet, daß** das Einbringen von Dotierstoffen in die Oberseite des Wafers (20) zur Veränderung des Leitfähigkeitstyps der ersten Schicht (2) die Belegung der Oberseite mit einer weiteren Dotierfolie (26) umfaßt, wobei die Dotieratome der weiteren Dotierfolie einen zu den Dotieratomen der Dotierfolie (24) für sehr starke Dotierung entgegengesetzten Leitfähigkeitstyp aufweisen.

5. Verfahren nach einem der vorhergehenden Ansprüche, **dadurch gekennzeichnet, daß** zeitgleich mit dem Einbringen von Dotierstoffen in die Oberseite des Wafers (20) zur Veränderung des Leitfähigkeitstyps der ersten Schicht (2) die Dotierung und/oder die Dicke der unten liegenden Teilschicht (5) verstärkt bzw. vergrößert wird.

6. Verfahren nach Anspruch 4 und 5, **dadurch gekennzeichnet, daß** die Verstärkung der Dotierung bzw. die Vergrößerung der Dicke der unten liegenden Teilschicht eine Belegung der Unterseite des Wafers mit der Dotierfolie (24) für sehr starke Dotierung umfaßt.

7. Verfahren nach einem der vorhergehenden Ansprüche, **dadurch gekennzeichnet, daß** die Bedeckung der Vorder- und Rückseite mit Dotierfolien in Waferstapeln erfolgt, so daß Vorder- und Rückseite jeder Dotierfolie im Stapelinnern mit einer Ober- oder mit einer Unterseite eines Wafers des Waferstapels in Berührung kommt.

8. Verfahren nach einem der Ansprüche 2-7, **dadurch gekennzeichnet, daß** zur Einstellung unterschiedlicher Zenerspannungen entweder die Dotierfolie (23) für die Belegung im ersten Diffusionsschritt oder die Dotierfolie (26) im zweiten Diffusionsschritt bezüglich des Dotierstoffgehaltes verändert oder die Belegungszeit mit der Dotierfolie (23) angepaßt werden.

9. Verfahren nach einem der vorhergehenden Ansprüche, **dadurch gekennzeichnet, daß** die Gräben (22) durch Sägen oder einen Ätzprozeß eingebracht werden.

10. Verfahren nach Anspruch 9, **dadurch gekennzeichnet, daß** vor dem Sägen der Wafer auf eine Sägefolie aufgebracht wird.

11. Verfahren nach einem der vorhergehenden Ansprüche, **dadurch gekennzeichnet, daß** der zweite Teilschritt wahlweise vor oder nach dem Einbringen der Gräben erfolgt.

## Claims

1. Method for producing semiconductor arrangements having the following method steps:
- production of a wafer (20) with an upper partial layer (3), a second partial layer (4) lying below the latter, and a partial layer (5) lying at the bottom, all the partial layers (3, 4, 5) having the same conduction type, the dopant concentration of the first partial layer (3) being greater than the dopant concentration of the second partial layer (4), and the dopant concentration of the partial layer (5) lying at the bottom being greater than the dopant concentrations of the upper and second partial layers,
- introduction of trenches (22) into the top side of the wafer (29), which reach through the first partial layer (3) right into the second partial layer (4),
- introduction of dopants into the top side of the wafer (20), which alter the conductivity type of a first layer (2) of the first partial layer (3),
- application of a metallization (6) on the top side and the underside of the wafer (20),
- division of the wafer into individual chips (1) along the introduced trenches (22),
- the partial layers (3, 4, 5) being produced by a procedure in which
- in a first partial step, the top side is coated with a strong concentration of doping atoms and the underside is coated with a very strong concentration of doping atoms and,
- in a further partial step, the doping atoms are driven in, the top side being covered with a neutral film and the underside being covered with a doping film (24) for very heavy doping.

2. Method according to Claim 1, **characterized in that**, in the first partial step, the top side is covered with a doping film (23) for heaving doping and the underside is covered with the doping film (24) for very heavy doping.

3. Method according to Claim 1, **characterized in that** the first partial step is effected by means of a vapour phase deposition, by means of a spin-on method with a doping liquid and/or by means of ion implantation.

4. Method according to one of the. preceding claims, **characterized in that** the introduction of dopants into the top side of the wafer (20) for the purpose of altering the conductivity type of the first layer (2) comprises the coating of the top side with a further doping film (26), the doping atoms of the further doping film having an opposite conductivity type to the doping atoms of the doping film (24), for very heavy doping.

5. Method according to one of the preceding claims, **characterized in that** the doping and/or the thickness of the partial layer (5) lying at the bottom is intensified and/or increased at the same time as the introduction of dopants into the top side of the wafer (20) for the purpose of altering the conductivity type of the first layer (2).

6. Method according to Claims 4 and 5, **characterized in that** the intensification of the doping and/or the increasing of the thickness of the partial layer lying at the bottom comprises a coating of the underside of the wafer with the doping film (24) for very heavy doping.

7. Method according to one of the preceding claims, **characterized in that** the front and rear sides are covered with doping films in wafer stacks, so that the front and rear sides of each doping film within the stack come into contact with a top side or with an underside of a wafer of the wafer stack.

8. Method according to one of Claims 2-7, **characterized in that**, in order to set different zener voltages, either the doping film (23) for the coating in the first diffusion step or the doping film (26) in the second diffusion step is altered with regard to the dopant content or the coating time with the doping film (23) is adapted.

9. Method according to one of the preceding claims, **characterized in that** the trenches (22) are introduced by sawing or an etching process.

10. Method according to Claim 9, **characterized in that** the wafer is applied to a sawing film prior to sawing.

11. Method according to one of the preceding claims, **characterized in that** the second partial step is optionally effected before or after the introduction of the trenches.

## Revendications

1. Procédé de fabrication de dispositifs semi-conducteurs comprenant les étapes suivantes :
- on réalise une plaquette (20) ayant une couche partielle supérieure (30) et en dessous de celle-ci une seconde couche partielle (4) et en dessous de celle-ci une couche partielle (5), toutes les couches partielles (3, 4, 5) étant du même type de conductivité, la concentration en matière dopante de la première couche partielle (3) étant supérieure à la concentration en matière dopante de la seconde couche partielle (4) et la concentration en matière dopante de la couche partielle (5) située en dessous étant supérieure à la concentration en matière dopante de la couche partielle supérieure et de la seconde couche partielle,
- on réalise des sillons (22) dans la face supérieure de la plaquette (20) qui traverse la première couche partielle (3) pour arriver jusque dans la seconde couche partielle (4),
- on introduit des matières dopantes dans la face supérieure de la plaquette (20) qui modifient le type de conductivité d'une première couche (20) de la première couche partielle (3),
- on applique une métallisation (6) sur la face supérieure et la face inférieure de la plaquette (20),
- on divise la plaquette en puces (1) le long des sillons (22) réalisés, procédé selon lequel
on réalise les couches partielles (3, 4, 5) en :
- occupant au cours d'une première étape partielle, la face supérieure avec une concentration forte d'atomes dopants et la face inférieure avec une concentration très forte d'atomes dopants et
- dans une autre étape partielle on introduit les atomes dopants en couvrant la face supérieure d'un film neutre et la face inférieure d'un film dopant (24) pour un dopage très fort.

2. Procédé selon la revendication 1,
**caractérisé en ce que**
dans la première étape partielle on couvre la face supérieure avec un film dopant (23) pour un fort dopage et la face inférieure avec un film dopant (24) pour un très fort dopage.

3. Procédé selon la revendication 1,
**caractérisé en ce qu'**
on réalise la première étape partielle par dépôt en phase gazeuse, par un procédé d'enveloppement avec un liquide dopant et/ou par implantation ionique.

4. Procédé selon l'une des revendications précédentes,
**caractérisé en ce que**
l'introduction de la matière dopante dans la face supérieure de la plaquette (20) pour modifier le type de conductivité de la première couche (2) comprend l'occupation de la face supérieure avec un autre film dopant (26), et
les atomes dopants de cet autre film dopant ayant un type de conductivité opposé de celui des atomes dopants du fil dopant (24) correspondant au dopage très fort.

5. Procédé selon l'une des revendications précédentes,
**caractérisé en ce que**
simultanément avec l'introduction des matières dopantes dans la face supérieure de la plaquette (20) pour modifier le type de conductivité de la première couche (2) on amplifie ou on augmente le dopage et/ou l'épaisseur de la couche partielle (5) située en dessous.

6. Procédé selon la revendication 4 ou 5,
**caractérisé en ce que**
l'amplification du dopage ou l'augmentation de l'épaisseur de la couche partielle située en dessous consiste à occuper la face inférieure de la plaquette avec le film dopant (24) correspondant à un dopage très fort.

7. Procédé selon l'une des revendications précédentes,
**caractérisé en ce que**
l'occupation de la face avant et de la face arrière avec des films dopants dans les piles de plaquettes se fait de façon que la face avant et la face arrière de chaque film dopant arrivent en contact à l'intérieur de la pile avec la face supérieure ou avec la face inférieure d'une plaquette de la pile de plaquettes.

8. Procédé selon l'une des revendications 2 à 7,
**caractérisé en ce que**
pour régler des tensions Zener différentes on modifie le film dopant (23) pour l'occupation au cours de la première étape de diffusion ou le film dopant (26) pour la seconde étape de diffusion pour en modifier le contenu en matière dopante ou on adapte la durée d'occupation avec le film dopant (23).

9. Procédé selon l'une des revendications précédentes,
**caractérisé en ce qu'**
on réalise les sillons (22) à la scie ou par un procédé de gravure.

10. Procédé selon la revendication 9,
**caractérisé en ce qu'**
avant de scier la plaquette on applique un film de sciage.

11. Procédé selon l'une des revendications précédentes,
**caractérisé en ce que**
la seconde étape partielle se fait au choix avant ou après la réalisation des sillons.
